# EUROPEAN PATENT APPLICATION

(11) **EP 4 585 725 A1**
(43) Date of publication of application: **16.07.2025**
(21) Application number: 23862923.2
(22) Date of filing: 22.08.2023
(51) Int. Cl.: C30B 29/04, C23C 14/14, C23C 14/35, C23C 16/40, C30B 25/18, H01L 21/20

(54) **BASE SUBSTRATE, SINGLE CRYSTAL DIAMOND MULTILAYER SUBSTRATE, METHOD FOR PRODUCING BASE SUBSTRATE, AND METHOD FOR PRODUCING SINGLE CRYSTAL DIAMOND MULTILAYER SUBSTRATE**

(30) Priority: 07.09.2022 JP 2022141934
(71) Applicant: SHIN-ETSU CHEMICAL CO., LTD., Tokyo 1000005 (JP)
(72) Inventor: NOGUCHI, Hitoshi, Annaka-shi, Gunma 379-0195 (JP)
(74) Representative: Schicker, Silvia
(86) International application number: PCT/JP2023/030067
(87) International publication number: WO 2024/053384

(57) **Abstract**

The present invention is a method for producing an underlying substrate for a single crystal diamond laminate substrate, the method includes the steps of providing an initial substrate, and forming an intermediate layer including a single layer or a laminate film on the initial substrate containing at least a single crystal Ir film or a single crystal MgO film, in which the single crystal Ir film or the single crystal MgO film composing the intermediate layer is formed by using a mist CVD method. This provides the method for producing an underlying substrate, in which a single crystal diamond layer can be formed with a large area (large diameter), high crystallinity, few hillocks, few abnormal growth particles such as twin crystals, few dislocation defects, **etc.,** high purity, low stress, and high quality and applicable to an electronic and magnetic device.

## Description

### TECHNICAL FIELD

The present invention relates to an underlying substrate, a single crystal diamond laminate substrate, and a method for producing them.

### BACKGROUND ART

Diamond has a wide band gap of 5.47 eV at room temperature and is known as a wide bandgap semiconductor.

Among semiconductors, diamond has an extremely high dielectric breakdown electric field strength of 10 MV/cm, and a high-voltage operation can be performed. In addition, diamond has the highest thermal conductivity among known materials, and has an excellent heat radiation property thereby. Further, diamond has very large carrier mobility and saturated drift velocity and is suitable for a high speed device.

Accordingly, diamond has the highest Johnson performance index, which indicates a property as a radio-frequency and high power device, compared to semiconductors such as silicon carbide and gallium nitride, and is said to be an ultimate semiconductor thereby.

### CITATION LIST

### NON PATENT LITERATURE

Non Patent Document 1: H.Yamada, Appl. Phys. Lett.104, 102110 (2014).

### SUMMARY OF INVENTION

### TECHNICAL PROBLEM

As described above, diamond is expected to be used practically as a material for semiconductors or a material for electronic and magnetic devices, and supply of a diamond substrate with a large area and high quality is desired.

Currently, most of single crystal diamond for producing a diamond semiconductor is diamond referred to as Ib-type diamond which is synthesized using a highpressure-high-temperature method (HPHT). This Ib-type diamond contains a number of nitrogen impurities and can be obtained in a size of only approximately 8 mm square at maximum, and therefore has less practicability. Moreover, another method, referred to as a mosaic method, in which a large number of HPHT substrates (the diamond substrates synthesized by the HPHT method) are arranged in a row and joined together, has been proposed (Non-Patent Document 1), but the problem of imperfections in the joints remains.

In contrast, a vapor synthesis (Chemical Vapor Deposition: CVD) method can provide large-area diamonds having a diameter of approximately 6 inches (150 mm) with high purity when polycrystal diamonds are acceptable; however, single crystallization, which is generally suited for electronic devices, is difficult. This is because a combination of suitable materials, as an underlying substrate for forming the diamond with small differences in lattice constants and linear expansion coefficients with the diamond, has not been realized, for example, a difference in the lattice constant between the diamond and single crystal Si has even 34.3 %; therefore, it is very difficult to grow the diamond heteroepitaxially on a surface of the underlying substrate.

The present invention has been made to solve the above-described problem. An object of the present invention is to provide an underlying substrate capable of forming a single crystal diamond layer having a large area (large diameter), high crystallinity, few hillocks, few abnormal growth particles, few dislocation defects, etc., high purity, low stress, and high quality and applicable to an electronic and magnetic device, and a method for producing such a substrate. Moreover, another object is to provide a method for producing a single crystal diamond laminate substrate having such a single crystal diamond layer and a method for producing a single crystal diamond freestanding structure substrate.

### SOLUTION TO PROBLEM

To solve the above problem, the present invention provides a method for producing an underlying substrate for a single crystal diamond laminate substrate, the method comprising the steps of:
providing an initial substrate; and
forming an intermediate layer comprising a single layer or a laminate film on the initial substrate containing at least a single crystal Ir film or a single crystal MgO film, wherein
the single crystal Ir film or the single crystal MgO film composing the intermediate layer is formed by using a mist CVD method.

With such a method for producing an underlying substrate, the formation of the single crystal Ir film or the single crystal MgO film composing the intermediate layer is performed by using a mist CVD method, thus the formation of the single crystal Ir film or the single crystal MgO film each having a large diameter can be performed at a low cost. In addition, a film thickness uniformity of the intermediate layer can be improved. As a result, it is possible to produce the underlying substrate that can form a single crystal diamond layer having a large diameter, high crystallinity, few hillocks, few abnormal growth particles, few dislocation defects, etc., high purity, low stress, and high quality and suitable for an electronic and magnetic device.

In this case, the initial substrate is preferably any of a single crystal Si substrate, a single crystal α-Al₂O₃ substrate, a single crystal Fe substrate, a single crystal Ni substrate, and a single crystal Cu substrate.

These materials of the initial substrate have a small lattice mismatch with the materials of the intermediate layer, and thus epitaxial growth of the intermediate layer is easily enabled. Moreover, a substrate having a large diameter exceeding 6 inches (150 mm) can also be obtained, and the price thereof is relatively low.

In addition, the intermediate layer can be a laminate film further containing at least any one of a single crystal yttria-stabilized zirconia film, a single crystal SrTiO₃ film, and a single crystal Ru film.

By having such a laminate film, the intermediate layer can be appropriately designed to have the role of mitigating a lattice mismatch between the initial substrate and the diamond layer more appropriately.

Moreover, the initial substrate can be any of a Si {111} substrate, an α-Al₂O₃ {0001} substrate, a Fe {111} substrate, a Ni {111} substrate, and a Cu {111} substrate, and the intermediate layer can contain at least an Ir film {111} or an MgO film {111}.

Moreover, the intermediate layer can further contain at least any one of a yttria-stabilized zirconia film {111}, a SrTiO₃ film {111}, and a Ru film {0001}.

By having such an initial substrate and intermediate layer, the underlying substrate that can form a single crystal diamond {111} layer can be produced.

In this case, an outermost surface on the initial substrate can have an off angle in a crystal axis <-1-12> direction relative to a cubic crystal plane orientation {111} or can have an off angle in a crystal axis <10-10> or <11-20> direction relative to a hexagonal crystal plane orientation {0001}.

By providing the off angle in this way, the underlying substrate can be produced in which the single crystal diamond {111} layer having high crystallinity, few hillocks, few abnormal growths such as twin crystals, few dislocation defects, and high quality can be obtained more effectively.

Furthermore, in this case, the off angle of the outermost surface on the initial substrate can be in a range of +8.0° to +24.0° or -8.0° to -24.0°. Additionally, the off angle of the outermost surface on the initial substrate can be in a range of greater than +15.0° to +24.0° or less, or greater than -15.0° to - 24.0° or less.

By making the range such as this, qualitative improvement effect due to the off angle can be maximized.

Moreover, in this case, an outermost surface on the intermediate layer can have an off angle in a crystal axis <-1-12> direction relative to a cubic crystal plane orientation {111} or can have an off angle in a crystal axis <10-10> or <11-20> direction relative to a hexagonal crystal plane orientation {0001}.

By providing the off angle in this way, the underlying substrate can be produced in which the single crystal diamond {111} layer having high crystallinity, few hillocks, few abnormal growths such as twin crystals, few dislocation defects, and high quality can be obtained more effectively.

In this case, the off angle of the outermost surface on the intermediate layer can be in a range of +8.0° to +24.0° or -8.0° to -24.0°. Furthermore, the off angle of the outermost surface on the intermediate layer can be in a range of greater than +15.0° to +24.0° or less, or greater than -15.0° to -24.0° or less.

By making the range such as this, qualitative improvement effect due to the off angle can be maximized.

Moreover, in the inventive method for producing an underlying substrate, the initial substrate can be any of a Si {001} substrate, an α-Al₂O₃ {11-20} substrate, a Fe {001} substrate, a Ni {001} substrate, and a Cu {001} substrate, and the intermediate layer can contain at least an Ir film {001} or an MgO film {001}.

In addition, the intermediate layer can further contain at least any one of a yttria-stabilized zirconia film {001}, a SrTiO₃ film {001}, and a Ru film {11-20}.

By having such an initial substrate and intermediate layer, the underlying substrate that can form a single crystal diamond {001} layer can be produced.

In this case, the outermost surface on the initial substrate can have an off angle in a crystal axis <110> direction relative to a cubic crystal plane orientation {001} or can have an off angle in a crystal axis <10-10> or <0001> direction relative to a hexagonal crystal plane orientation {11-20}.

By providing the off angle in this way, the underlying substrate can be produced in which the single crystal diamond {001} layer having high crystallinity, few hillocks, few abnormal growths such as twin crystals, few dislocation defects, and high quality can be obtained more effectively.

Furthermore, in this case, the off angle of the outermost surface on the initial substrate can be in a range of +8.0° to +24.0° or -8.0° to -24.0°. Additionally, the off angle of the outermost surface on the initial substrate can be in a range of greater than +15.0° to +24.0° or less, or greater than -15.0° to - 24.0° or less.

By making the range such as this, qualitative improvement effect due to the off angle can be maximized.

Moreover, in this case, the outermost surface on the intermediate layer can have an off angle in a crystal axis <110> direction relative to a cubic crystal plane orientation {001} or can have an off angle in a <10-10> or <0001> direction relative to a hexagonal crystal plane orientation {11-20}.

By providing the off angle in this way, the underlying substrate can be produced in which the single crystal diamond {001} layer having high crystallinity, few hillocks, few abnormal growths such as twin crystals, few dislocation defects, and high quality can be obtained more effectively.

In this case, the off angle of the outermost surface on the intermediate layer can be in a range of +8.0° to +24.0° or -8.0° to -24.0°. Furthermore, the off angle of the outermost surface on the intermediate layer can be in a range of greater than +15.0° to +24.0° or less, or greater than -15.0° to -24.0° or less.

By making the range such as this, qualitative improvement effect due to the off angle can be maximized.

In addition, the present invention provides a method for producing a single crystal diamond laminate substrate, the method comprising the steps of:
providing an underlying substrate produced by any of the methods for producing an underlying substrate described above;
performing a bias treatment on a surface of the intermediate layer of the underlying substrate to form a diamond nucleus; and
growing the diamond nucleus formed on the intermediate layer to perform epitaxial growth, thereby forming a single crystal diamond layer.

According to such a production method, the single crystal diamond laminate substrate can be produced. This substrate includes the single crystal diamond layer with a large diameter, high crystallinity, few hillocks, few abnormal growth particles such as twin crystals, few dislocation defects, etc., high purity, low stress, and high quality and suitable for an electronic and magnetic device.

In the inventive method for producing a single crystal diamond laminate substrate, the single crystal diamond layer can be a {111} crystal.

Alternatively, the single crystal diamond layer can also be a {001} crystal.

In the inventive method for producing a single crystal diamond laminate substrate, the single crystal diamond layer having these plane orientations can be formed.

In addition, the present invention provides a method for producing a single crystal diamond freestanding structure substrate, the method comprising taking out only the single crystal diamond layer from a single crystal diamond laminate substrate produced by any of the methods for producing a single crystal diamond laminate substrate described above to produce a single crystal diamond freestanding structure substrate.

In this way, the single crystal diamond freestanding structure substrate composed of only the single crystal diamond layer can be produced.

Moreover, it is possible to further form an additional single crystal diamond layer on a single crystal diamond freestanding structure substrate obtained by the method for producing a single crystal diamond freestanding structure substrate described above.

In this way, it is also possible to further thicken a film by further performing additional forming on the substrate having only the diamond layer.

Moreover, the present invention provides an underlying substrate for a single crystal diamond laminate substrate, the underlying substrate comprising:
an initial substrate; and
an intermediate layer comprising a single layer or a laminate film on the initial substrate containing at least a single crystal Ir film or a single crystal MgO film, wherein
a film thickness uniformity of the intermediate layer on an entire surface is within ±10%.

In this way, according to the inventive underlying substrate, the film thickness uniformity of the intermediate layer on the entire surface can be within ±10%. As a result, it is possible to provide the underlying substrate that can form a single crystal diamond layer having a large diameter, high crystallinity, few hillocks, few abnormal growth particles, few dislocation defects, etc., high purity, low stress, and high quality and suitable for an electronic and magnetic device.

In this case, the initial substrate can be any of a single crystal Si substrate, a single crystal α-Al₂O₃ substrate, a single crystal Fe substrate, a single crystal Ni substrate, and a single crystal Cu substrate.

These materials of the initial substrate have a small lattice mismatch with the materials of the intermediate layer, and thus epitaxial growth of the intermediate layer 21 is easily enabled. Moreover, a substrate having a large diameter exceeding 6 inches (150 mm) can also be obtained, and the price thereof is relatively low.

Moreover, the intermediate layer can be a laminate film further containing at least any one of a single crystal yttria-stabilized zirconia film, a single crystal SrTiO₃ film, and a single crystal Ru film.

By having such a laminate film, the intermediate layer can be appropriately designed to have the role of mitigating a lattice mismatch between the initial substrate and the diamond layer more appropriately.

In addition, the underlying substrate can be a substrate in which the initial substrate is any of a single crystal Si {111} substrate, a single crystal Si {001} substrate, a single crystal α-Al₂O₃ {0001} substrate, a single crystal α-Al₂O₃ {11-20} substrate, a single crystal Fe {111} substrate, a single crystal Fe {001} substrate, a single crystal Ni {111} substrate, a single crystal Ni {001} substrate, a single crystal Cu {111} substrate, and a single crystal Cu {001} substrate, and an outermost surface on the initial substrate has an off angle in a crystal axis <-1-12> direction relative to a cubic crystal plane orientation {111}, or has an off angle in a crystal axis <10-10> or <11-20> direction relative to a hexagonal crystal plane orientation {0001}, or has an off angle in a crystal axis <110> direction relative to a cubic crystal plane orientation {001}, or has an off angle in a crystal axis <10-10> or <0001> direction relative to a hexagonal crystal plane orientation {11-20}.

With such an underlying substrate; the initial substrate, the off angle thereof, and the intermediate layer are appropriately combined to enable the underlying substrate to form a single crystal diamond layer having a large diameter, high crystallinity, few hillocks, few abnormal growth particles, few dislocation defects, etc., higher purity, lower stress, and high quality and suitable for the electronic and magnetic device.

Moreover, the underlying substrate can be a substrate in which the off angle of an outermost surface on the initial substrate is in a range of +8.0° to +24.0° or -8.0° to -24.0°. Furthermore, the underlying substrate can be a substrate in which the off angle of the outermost surface on the initial substrate is in a range of greater than +15.0° to +24.0° or less, or greater than -15.0° to -24.0° or less.

By making the range such as this, qualitative improvement effect due to the off angle can be maximized.

Moreover, the underlying substrate can be a substrate in which the outermost surface on the intermediate layer has an off angle in a crystal axis <-1-12> direction relative to a cubic crystal plane orientation {111}, or has an off angle in a crystal axis <10-10> or <11-20> direction relative to a hexagonal crystal plane orientation {0001}, or has an off angle in a crystal axis <110> direction relative to a cubic crystal plane orientation {001}, or has an off angle in a crystal axis <10-10> or <0001> direction relative to a hexagonal crystal plane orientation {11-20}.

By providing the off angle in this way, the underlying substrate can be a substrate in which the single crystal diamond layer having high crystallinity, few hillocks, few abnormal growths such as twin crystals, few dislocation defects, etc., and high quality can be obtained more effectively.

The underlying substrate can be a substrate in which the off angle of the outermost surface on the intermediate layer is in a range of +8.0° to +24.0° or - 8.0° to -24.0°. Furthermore, the underlying substrate can be a substrate in which the off angle of the outermost surface on the intermediate layer is in a range of greater than +15.0° to +24.0° or less, or greater than -15.0° to -24.0° or less.

By making the range such as this, qualitative improvement effect due to the off angle can be maximized.

Moreover, the present invention provides a single crystal diamond laminate substrate comprising a single crystal diamond layer on the intermediate layer of any of the underlying substrates described above.

Since such a single crystal diamond laminate substrate has the single crystal diamond layer formed on the intermediate layer having the film thickness uniformity of the intermediate layer on an entire surface being within ±10%, it is possible to provide the single crystal diamond laminate substrate that includes the single crystal diamond layer having a large diameter, high crystallinity, few hillocks, few abnormal growth particles, few dislocation defects, etc., high purity, low stress, and high quality and suitable for the electronic and magnetic device.

### ADVANTAGEOUS EFFECTS OF INVENTION

According to the inventive method for producing an underlying substrate, the formation of the single crystal Ir film or the single crystal MgO film composing the intermediate layer is performed by using a mist CVD method, thus the formation of the single crystal Ir film or the single crystal MgO film both having a large diameter can be performed at a low cost. The film thickness uniformity of the intermediate layer can be improved, in particular, the film thickness uniformity of the intermediate layer on an entire surface can be within ±10%. As a result, it is possible to produce the underlying substrate that can form the single crystal diamond layer having a large diameter, high crystallinity, few hillocks, few abnormal growth particles such as twin crystals, few dislocation defects, etc., high purity, low stress, and high quality and suitable for the electronic and magnetic device. In addition, by forming the single crystal diamond layer on this underlying substrate, it is possible to produce the single crystal diamond laminate substrate having the single crystal diamond layer that has characteristics described above. Moreover, according to the present invention, the single crystal diamond freestanding structure substrate can be produced in which only the single crystal diamond laminate layer is separated from such a single crystal diamond laminate substrate; further, the single crystal diamond freestanding structure substrate can be produced on which an additional single crystal diamond layer is formed on the single crystal diamond freestanding structure substrate.

### BRIEF DESCRIPTION OF DRAWINGS

FIG. 1 is a flowchart illustrating an example of a method for producing an underlying substrate according to the present invention.
FIG. 2 is a flowchart illustrating an example of a process of a method for producing a single crystal diamond laminate substrate and a process of a method for producing a single crystal freestanding structure substrate according to the present invention.
FIG. 3 is a schematic view illustrating an example of an underlying substrate according to the present invention.
FIG. 4 is a schematic view illustrating an example of a single crystal diamond laminate substrate according to the present invention.
FIG. 5 is a schematic view illustrating another example of an underlying substrate according to the present invention.
FIG. 6 is a schematic view illustrating another example of a single crystal diamond laminate substrate according to the present invention.
FIG. 7 is a schematic view illustrating an example of a single crystal diamond freestanding structure substrate according to the present invention.
FIG. 8 is a schematic view illustrating another example of a single crystal diamond freestanding structure substrate according to the present invention.

### DESCRIPTION OF EMBODIMENTS

Hereinafter, the present invention will be described in detail. However, the present invention is not limited thereto.

As described above, conventionally, it has been desired to obtain a single crystal diamond laminate substrate having a large diameter and high quality at a low cost. Accordingly, the present inventor has earnestly studied to solve such a problem. As a result, the inventor has found that adopting a mist CVD method is the most suitable method for forming an intermediate layer in both a single crystal diamond laminate substrate and an underlying substrate for producing the single crystal diamond laminate substrate. This finding has led to the completion of the present invention.

The present invention is a method for producing an underlying substrate for a single crystal diamond laminate substrate, the method comprising the steps of:
providing an initial substrate; and
forming an intermediate layer comprising a single layer or a laminate film on the initial substrate containing at least a single crystal Ir film or a single crystal MgO film, wherein
the single crystal Ir film or the single crystal MgO film composing the intermediate layer is formed by using a mist CVD method.

Hereinafter, the present invention will be more specifically described, referring to the drawings. Similar components below are described with the same reference signs.

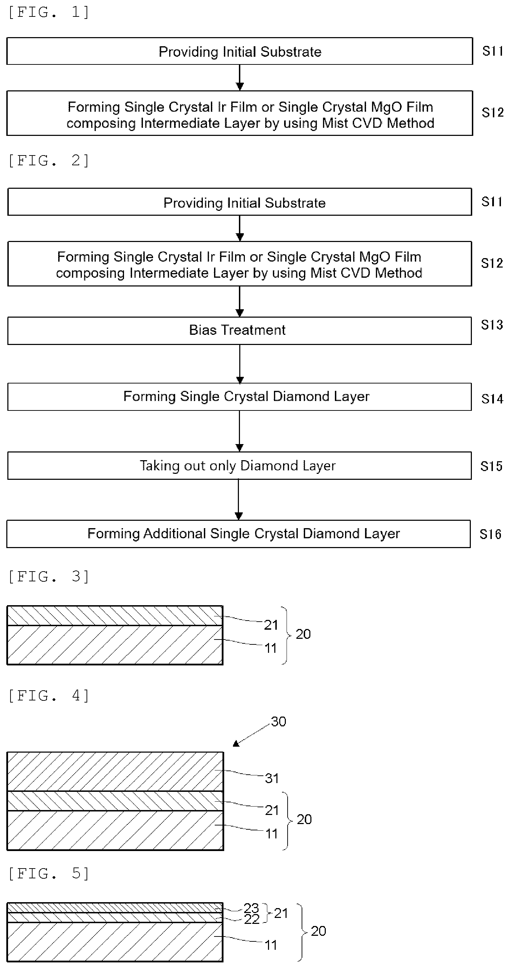

First, the inventive underlying substrate and the inventive single crystal diamond laminate substrate are described, referring to FIGs. 3 and 4.

As shown in FIG. 3, the inventive underlying substrate 20 for the single crystal diamond laminate substrate includes an initial substrate 11 and an intermediate layer 21 on the initial substrate 11. In the present invention, the intermediate layer 21 includes a single layer or a laminate film containing at least the single crystal Ir film or the single crystal MgO film. Moreover, in the present invention, a film thickness uniformity of the intermediate layer 21 on an entire surface can be within ±10%. Such a film thickness uniformity of the intermediate layer 21 can be easily achieved by adopting the mist CVD method described later.

The film thickness uniformity of the intermediate layer (film thickness distribution) according to the present invention is calculated by measuring 9 or more points in the surface across the entire surface of the intermediate layer and using the following formula. Film thickness uniformity [±%] = (Maximum film thickness - Minimum film thickness)/((Average film thickness) × 2) × 100

The film thickness can be measured by a step-type thickness gauge, an optical interference thickness gauge, etc., the measurement method is not particularly limited as long as the film thickness at each point can be measured.

Moreover, as shown in FIG. 4, the inventive single crystal diamond laminate substrate 30 includes a single crystal diamond layer 31 on the intermediate layer 21 of the underlying substrate 20 shown in FIG. 3. The intermediate layer 21 has a role in mitigating a lattice mismatch between the initial substrate 11 and the single crystal diamond layer 31.

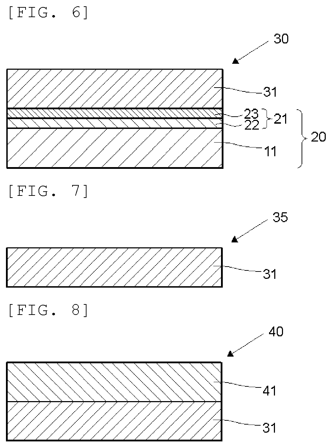

In the inventive underlying substrate 20, the intermediate layer 21 may be composed of the single crystal Ir film alone, or may also be the single crystal MgO film alone, but it is more preferable to be a laminate film composed of these films. In particular, as shown in FIG. 5, it is preferable that the intermediate layer 21 on the initial substrate 11 is a laminate film composed of the single crystal MgO film 22 and the single crystal Ir film 23. The intermediate layer 21 of the inventive underlying substrate 20 can also be a laminate film containing at least any one of the single crystal Ir film or the single crystal MgO film, additionally, further containing at least any one of a single crystal yttria-stabilized zirconia (YSZ) film, a single crystal SrTiO₃ film, and a single crystal Ru film. Such a laminate film can be designed to have the role of mitigating a lattice mismatch between the initial substrate 11 and the single crystal diamond layer 31 more appropriately. As shown in FIG. 5, when the intermediate layer 21 on the initial substrate 11 is the laminate film composed of the single crystal MgO film 22 and the single crystal Ir film 23, then naturally, by producing the single crystal diamond laminate substrate 30, the intermediate layer 21 becomes the laminate film composed of the single crystal MgO film 22 and the single crystal Ir film 23 as shown in FIG. 6.

In addition, in the present invention, the initial substrate 11 is preferably any of a single crystal Si substrate, a single crystal α-Al₂O₃ substrate, a single crystal Fe substrate, a single crystal Ni substrate, and a single crystal Cu substrate. Since these initial substrates 11 (bulk substrates) have a small lattice mismatch with materials of the intermediate layer 21; thus, epitaxial growth of the intermediate layer 21 can be performed easily when the intermediate layer 21 is formed. Moreover, a substrate having a large diameter exceeding 6 inches (150 mm) can also be obtained, and the price thereof can be relatively low.

Hereinafter, the method for producing an underlying substrate and a method for producing a single crystal diamond laminate substrate shown in FIGs. 3 to 6 are described. The inventive method for producing the underlying substrate is described, referring to FIG. 1, and the inventive method for producing the single crystal diamond laminate substrate is described referring to FIG. 2. In addition, in the present invention, it is possible to produce a single crystal diamond freestanding structure substrate 35 composed of the single crystal diamond layer 31 shown in FIG. 7, and a single crystal diamond freestanding structure substrate composed of the single crystal diamond layer 31 and an additional single crystal diamond layer 41 shown in FIG. 8. The methods for producing these substrates are also described, referring to FIG. 2.

### (Providing Step: Step S11 in FIG. 1)

First, the initial substrate 11 is provided (Step S11). The initial substrate 11 is preferably any of the substrates (bulk substrates) including a single crystal Si substrate, a single crystal α-Al₂O₃ substrate, a single crystal Fe substrate, a single crystal Ni substrate, and a single crystal Cu substrate. These listed materials of the initial substrate 11 have a small lattice mismatch with materials of the intermediate layer 21; thus, epitaxial growth of the intermediate layer 21 can be performed easily. Moreover, the substrate having a large diameter exceeding 6 inches (150 mm) can be obtained, and a price thereof is relatively low.

When the above substrates are used for the initial substrate 11, and plane orientations thereof are prescribed accordingly, the initial substrate 11 can be any of a Si {111} substrate, an α-Al₂O₃ {0001} substrate, a Fe {111} substrate, a Ni {111} substrate, and a Cu {111} substrate. Alternatively, the initial substrate 11 can be any of a Si {001} substrate, an α-Al₂O₃ {11-20} substrate, a Fe {001} substrate, a Ni {001} substrate, and a Cu {001} substrate.

It is preferred that a surface of the initial substrate 11 where the intermediate layer 21 is formed is polish processed to make Ra≤0.5 nm. Accordingly, a smooth intermediate layer with few defects can be formed.

When it is desired to obtain a crystal plane orientation {111} for the single crystal diamond layer 31, the outermost surface of the initial substrate 11 can be made to have the off angle in the crystal axis <-1-12> direction relative to the cubic crystal plane orientation {111} or have the off angle in the crystal axis <10-10> or <11-20> direction relative to the hexagonal crystal plane orientation {0001}. By providing the off angle on the outermost surface of the initial substrate 11, the high quality intermediate layer 21 having high crystallinity, few hillocks, few abnormal growths such as twin crystals, few dislocation defects, etc., can be obtained more effectively as the intermediate layer 21 formed on the surface.

It is preferred that the off angle on the outermost surface of the initial substrate 11 at this time is in a range of +8.0° to +24.0° or -8.0° to -24.0°. When this off angle is +8.0° or more and -8.0° or more, an effect of providing the off angle can be obtained sufficiently, and when the off angle is +24.0° or less and -24.0° or less, a qualitative improvement effect can be sufficiently obtained. In addition, when the off angles are within these ranges, a deviation from a crystal plane {111} of the outermost surface is not too large; thus, it is easy to use according to an intended purpose.

Furthermore, the off angle on the outermost surface of the initial substrate 11 is more preferably in a range of greater than +15.0° to +24.0° or less, or greater than -15.0° to -24.0° or less. With such a range of the off angle, an effect of providing the off angle can be obtained sufficiently and more stably, and a qualitative improvement effect can be obtained sufficiently and more stably.

On the other hand, when it is desired to obtain a crystal plane orientation {001} for the single crystal diamond layer, the outermost surface of the initial substrate 11 can be made to have the off angle in the crystal axis <110> direction relative to the cubic crystal plane orientation {001} or have the off angle in the crystal axis <10-10> or <0001> direction relative to the hexagonal crystal plane orientation {11-20}. By providing the off angle on the outermost surface of the initial substrate 11, the high quality intermediate layer 21 having high crystallinity, few hillocks, few abnormal growths such as twin crystals, few dislocation defects, etc., can be obtained more effectively as the intermediate layer 21 formed on the surface.

It is preferred that the off angle on the outermost surface of the initial substrate 11 at this time is in a range of +8.0° to +24.0° or -8.0° to -24.0°. When this off angle is +8.0° or more and -8.0° or more, an effect of providing the off angle can be obtained sufficiently, and when the off angle is +24.0° or less and -24.0° or less, a qualitative improvement effect can be sufficiently obtained. In addition, when the off angles are within these ranges, a deviation from a crystal plane {111} of the outermost surface is not too large; thus, it is easy to use according to an intended purpose.

Furthermore, when the off angle is provided on the outermost surface of the initial substrate 11, the off angle thereof is more preferably in a range of greater than +15.0° to +24.0° or less, or greater than -15.0° to -24.0° or less. With such a range of the off angle, an effect of providing the off angle can be obtained sufficiently and more stably, and a qualitative improvement effect can be obtained sufficiently and more stably.

### (Forming Intermediate Layer Step: Step S12 in FIG. 1)

After providing the initial substrate 11 in the step S11, the intermediate layer 21, which includes a single layer or a laminate film each containing at least the single crystal Ir film or the single crystal MgO film, is then formed on the initial substrate 11 (Step S12). Here, the feature of the present invention is that the formation of the single crystal Ir film or the single crystal MgO film composing the intermediate layer 21 is performed using the mist CVD method.

In addition, the intermediate layer 21 can be a laminate film further containing at least any one of a single crystal yttria-stabilized zirconia (YSZ) film, a single crystal SrTiO₃ film, and a single crystal Ru film.

When it is desired to obtain a crystal plane orientation {111} as the single crystal diamond layer 31, at least the outermost surface of the intermediate layer 21 may also be made to the crystal plane orientation {111} in a case of the cubic crystal, and {0001} in a case of the hexagonal crystal. In this case, the intermediate layer 21 can contain at least an Ir film {111} or an MgO film {111}. Moreover, the intermediate layer 21 may further contain at least any one of a yttria-stabilized zirconia film {111}, a SrTiO₃ film {111}, and a Ru film {0001}.

On the other hand, when it is desired to obtain a crystal plane orientation {001} as the single crystal diamond layer 31, at least the outermost surface of the intermediate layer 21 may also be made to the crystal plane orientation {001} in a case of the cubic crystal, and the crystal plane orientation {11-20} in a case of the hexagonal crystal. In this case, the intermediate layer can contain at least an Ir film {001} or an MgO film {001}. Moreover, the intermediate layer 21 can further contain at least any one of a yttria-stabilized zirconia film {001}, a SrTiO₃ film {001}, and a Ru film {11-20}.

In the present invention, the formation of the single crystal Ir film or the single crystal MgO film composing the intermediate layer 21 is performed by using the mist CVD method as described above. When the mist CVD method is used for at least one layer composing the intermediate layer 21, an effect of the present invention can be obtained. The formation of other layers composing intermediate layer 21 can also be performed by a sputtering method, an electron beam vapor-deposition method, an atomic layer deposition method, a molecular beam epitaxy method, a pulsed laser deposition method, etc., in addition to the mist CVD method. Regarding the films that can compose the intermediate layer listed above such as the single crystal Ir film, the single crystal MgO film, the single crystal yttria-stabilized zirconia (YSZ) film, the single crystal SrTiO₃ film, and the single crystal Ru film, which are the metals and metal oxides, it is preferable to use the mist CVD method which allows for a large-diameter film at low-cost.

A film-forming apparatus using the mist CVD method is configured with a mist-atomizing unit to atomize a raw material solution, in which atoms of materials to be formed are contained, into the mist by an ultrasonic vibration to generate the mist; a carrier gas supply unit to supply a carrier gas for transporting the mist; a chamber in which a substrate is set to form the film; and an exhaust system to discharges unnecessary raw material.

The substrate is heated on a heater stage in the chamber and rotated and the like as necessary so as to enable highly crystallized and uniform film formation. A raw material gas flow is also controlled to allow for highly crystallized and uniform film formation.

Additionally, the substrate can be placed on the heater stage installed in an open system, and then the film forming can be performed by thermal reaction by supplying the mist from a mist discharge nozzle onto a surface of the substrate.

The material contained in the raw material solution is not particularly limited and may be inorganic or organic material as long as the raw material solution contains at least metal atoms to be formed and can be atomized into the mist.

The raw material solution is not particularly limited as long as the metal atom described above can be atomized into the mist, but the metal dissolved or dispersed into an organic solvent or water in a form of a complex or a salt can be suitably used as the raw material solution. As the forms of complexes, for example, acetylacetonate complex, carbonyl complex, ammine complex, and hydride complex, etc., can be exemplified. As the forms of salts, for example, metal chloride salt, metal bromide salt, metal iodide salt, etc., are exemplified. In addition, the above metal dissolved in hydrobromic acid, hydrochloric acid, hydrogen iodide, etc., can be used as a salt aqueous solution.

Moreover, an additive such as hydrohalic acid and oxidizing agent may also be mixed in the raw material solution. As to hydrohalic acid, for example, hydrobromic acid, hydrochloric acid, hydroiodic acid, etc., are exemplified, among which hydrobromic acid and hydroiodic acid are preferred. As to the oxidizing agents, for example, peroxides such as hydrogen peroxide, sodium peroxide, barium peroxide, benzoyl peroxide, etc., organic peroxides such as hypochlorous acid, perchloric acid, nitric acid, ozonated water, peracetic acid, and nitrobenzene, etc., are also exemplified.

As to the raw material solution for forming MgO, magnesium chloride aqueous solution can also be used.

To obtain an oxide composed of multi-element metal, a plurality of raw material solutions may be mixed to atomize into the mist or each element may be atomized into the mist as separated raw material solutions.

It is preferred to form the film by heating in a substrate temperature range of 200 to 1000°C.

As described above, the intermediate layer 21, which is of excellent quality, can be realized not only by the single layer made of the above material but also by the laminated structure. For example, by forming the laminated structure in which order can be from the surface side of the underlying substrate 20 to the Ir film/MgO film and then to the initial substrate 11 side; similarly, by forming the laminated structure including the Ir film/YSZ film or the Ir film/SrTiO₃ film, the role to mitigate the lattice mismatch can be given more effectively. FIG. 5 is an example in which the single crystal MgO film 22 and the single crystal Ir film 23 are laminated on the initial substrate 11, as described above. This case is an example in which order is from the surface side of the underlying substrate 20 to the Ir film/MgO film and then to the initial substrate 11 side.

It is preferred that the intermediate layer 21 has a thickness of 5 nm or more and 50 µm or less. When the intermediate layer 21 has a thickness of 5 nm or more, such a layer is not removed in a subsequent diamond-forming step. Moreover, when the intermediate layer 21 has a thickness of 50 µm or less, the thickness thereof is sufficient as the thickness of the intermediate layer 21. In addition, when the thickness is 50 µm or less, the time for film-forming is not too long, and surface roughness can be maintained low. Consequently, polish processing is not necessarily required. Thus, the film-forming at a low cost is possible.

The outermost surface on the intermediate layer 21 can have the off angle in the crystal axis <-1-12> direction relative to the cubic crystal plane orientation {111} or can have the off angle in the crystal axis <10-10> or <11-20> direction relative to the hexagonal crystal plane orientation {0001}. As a result, a high quality single crystal diamond {111} layer having high crystallinity, few hillocks, few abnormal growths such as twin crystals, few dislocation defects, etc., can be obtained more effectively as the single crystal diamond layer 31 formed on the surface.

In this event, it is preferred that the off angle of the outermost surface on the intermediate layer 21 is in a range of +8.0° to +24.0° or -8.0° to -24.0°. When this off angle is +8.0° or more and -8.0° or more, an effect of providing the off angle can be obtained sufficiently, and when the off angle is +24.0° or less and -24.0° or less, a qualitative improvement effect can be obtained sufficiently. In addition, when within these ranges, a deviation from a {111} crystal plane of the outermost surface is not too large; thus, it is easy to use according to an intended purpose.

Moreover, it is more preferred that the off angle of the outermost surface on the intermediate layer 21 is in a range of greater than +15.0° to +24.0° or less, or greater than -15.0° to -24.0° or less. With such a range of the off angle, an effect of providing the off angle can be obtained sufficiently and more stably, and a qualitative improvement effect can be obtained sufficiently and more stably.

By having the off angle in the crystal axis <110> direction relative to the plane orientation {001} of the cubic crystal or the off angle in the <10-10> or <0001> direction relative to the hexagonal crystal plane orientation {11-20}; thus, a high quality single crystal diamond {001} layer having high crystallinity, few hillocks, few abnormal growths such as twin crystals, few dislocation defects, etc., can be obtained as the diamond formed on the surface.

In this event, it is preferred that the off angle of the outermost surface on the intermediate layer 21 is in a range of +8.0° to +24.0° or -8.0° to -24.0°. When this off angle is +8.0° or more and -8.0° or more, an effect of providing the off angle can be obtained sufficiently, and when the off angle is +24.0° or less and -24.0° or less, a qualitative improvement effect can be obtained sufficiently. In addition, when within these ranges, a deviation from a {001} crystal plane of the outermost surface is not too large; thus, it is easy to use according to an intended purpose.

Furthermore, it is more preferred that the off angle of the outermost surface on the intermediate layer 21 is in a range of greater than +15.0° to +24.0° or less, or greater than -15.0° to -24.0° or less. With such a range of the off angle, an effect of providing the off angle can be obtained sufficiently and more stably, and a qualitative improvement effect can be obtained sufficiently and more stably.

By the steps S11 and S12 in FIG. 1 above, the inventive underlying substrate 20 (see FIGs. 3 and 5) can be produced.

Furthermore, the present invention provides a method for producing a single crystal diamond laminate substrate 30; the method includes the steps of providing the underlying substrate 20 produced by the method for producing the underlying substrate 20 as described above, performing a bias treatment on a surface of the intermediate layer 21 of the underlying substrate 20 to form a diamond nucleus, and growing the diamond nucleus formed on the intermediate layer 21 to perform epitaxial growth, thereby forming the single crystal diamond layer 31. Hereinafter, a description is given in more detail.

S11 and S12 in FIG. 2 are the same steps with S11 and S12 in FIG. 1. The underlying substrate 20 is produced by the steps S11 and 12. Moreover, the single crystal diamond laminate substrate 30 is produced by performing the following steps S13 and S14 shown in FIG. 2.

### (Bias Treatment Step: S13 in FIG. 2)

The bias treatment is performed on the surface of the intermediate layer 21 of the underlying substrate 20 to form the diamond nucleus (Step S13). The underlying substrate 20, in which the intermediate layer 21 has been formed, is set in a decompression chamber, and after the chamber is depressurized by a vacuum pump, the nucleus of the diamond that has a crystal orientation aligned with the outermost surface of the intermediate layer 21 is formed by a direct-current discharge. The discharge gas is preferably hydrogen-diluted methane.

### (Single Crystal Diamond Layer Step: S14 in FIG. 2)

Next, the diamond nucleus formed on the intermediate layer 21 is grown to perform epitaxial growth, thereby forming the single crystal diamond layer 31 (Step S14). That is, a single crystal layer is formed on the bias-treated underlying substrate 20. This step can be performed by, e.g., microwave plasma CVD, DC plasma CVD, thermal filament CVD, or arc discharge CVD, which are chemical vapor deposition (CVD) methods.

The single crystal diamond layer 31 can be composed of each of the single layers of an undoped or doped diamond or a laminated structure of the undoped and the doped diamond.

By the steps S13 and S14, which follow steps S11 and S12 above, the inventive single crystal diamond laminate substrate 30 (see FIGs. 4 and 6) can be produced.

Moreover, in the method for producing a single crystal diamond laminate substrate described above, the single crystal diamond {111} can be obtained by making the crystal orientation to {111} for cubic crystal, {0001} for hexagonal crystal in either or both of the initial substrate 11 and intermediate layer 21.

On the other hand, in the method for producing a single crystal diamond laminate substrate described above, the single crystal diamond {001} can be obtained by making the crystal orientation to {001} for cubic crystal, {11-20} for hexagonal crystal in either or both of the initial substrate 11 and intermediate layer 21.

The present invention also provides a method for producing a single crystal diamond freestanding structure substrate, the method includes taking out only the single crystal diamond layer 31 from the single crystal diamond laminate substrate 30 produced through the steps S11 to S14 by the above method to produce a single crystal diamond freestanding structure substrate 35 (see FIG. 7). Hereinafter, the description is given in more detail.

### (Single Crystal Diamond Taking Out Step: S15 in FIG. 2)

In this step, after the single crystal diamond layer 30 forming step (Step S14), only the single crystal diamond layer 31 is made into the single crystal diamond freestanding structure substrate 35 (Step S15). Such freestanding substrate-making can be performed using a chemical etching method, a laser irradiation method, a polish processing method, etc.

By making the substrate freestanding, a response to a process has an advantage of becoming easier in subsequent additional film forming and device processing.

Moreover, also in the case of using the diamond as an electronic and magnetic device, the single crystal diamond freestanding structure substrate composed of only the single crystal diamond layer may be favorable since no influence from the intermediate layer or below is present.

### (Single Crystal Diamond Additional Forming Step: S16 in FIG. 2)

Furthermore, in the present invention, an additional single crystal diamond layer 41 is further formed on the single crystal diamond freestanding structure substrate 35 obtained up to the step S15 (Step S16), thereby producing the single crystal diamond freestanding structure substrate 40 (see FIG. 8). That is, the additional forming can be performed on the single crystal diamond freestanding structure substrate 35 composed of only the single crystal diamond layer 31 shown in FIG. 7. Because the film is formed on a single material, breakage is absent and it is effective in lowering the stress. This step is also advantageous for thickening a diamond film.

The additional single crystal diamond layer 41 formed in this step may be undoped, doped, or a combination thereof.

When a surface of the single crystal diamond freestanding structure substrate 35, to be an underlayer, is polish processed before the additional forming of the additional single crystal diamond layer 41, a crystal being smooth with few defects can be obtained.

According to the inventive underlying substrate, the inventive single crystal diamond laminate substrate, and the inventive method for producing a single crystal diamond freestanding structure substrate described above, the method can be provided in which the laminate substrate having the single crystal diamond layer with a large diameter, high crystallinity, few hillocks, few abnormal growth particles such as twin crystals, few dislocation defects, etc., high purity, low stress, and high quality and suitable for the electronic and magnetic device is produced at low cost.

### EXAMPLE

Hereinafter, the present invention will be specifically described with reference to Examples and Comparative Examples. However, the present invention is not limited to Examples described below.

### (Example 1)

A single crystal α-Al₂O₃ wafer having a diameter of 150 mm, a thickness of 1000 µm, and a crystal plane orientation {0001}, an off angle of +16° in <11-20> direction, and double-side polished was provided as an initial substrate 11 (Step S11 in FIGs. 1 and 2).

Next, an MgO film was heteroepitaxially grown by a mist CVD method on a surface of the initial substrate to form a first layer of an intermediate layer 21 (single crystal MgO film 22 in FIG. 5) under the following conditions (Step S12 in FIGs 1 and 2).

A "magnesium oxide aqueous solution" was used as a raw material solution in the mist CVD method. The raw material solution described above was stored in a mist generation source. Next, the flow rate control valve was opened to supply carrier gas from the carrier gas source into the chamber, and after sufficiently replacing the atmosphere in the chamber with the carrier gas, the flow rate of the carrier gas was adjusted to 10000 sccm, and the flow rate of the carrier gas for dilution was adjusted to 30000 sccm respectively. Oxygen was used as a carrier gas.

Next, an ultrasonic vibrator was vibrated at 2.4 MHz, and the vibration was propagated to the raw material solution through water, thereby atomizing the raw material solution to generate a mist. The mist was introduced into the chamber via a supply pipe by the carrier gas. Under atmospheric pressure, the initial substrate was set on a hot plate in a chamber and heated to 800°C, and the mist was caused to thermally react with the initial substrate to heteroepitaxially grow an MgO (111) film on the surface of the initial substrate 11 to a thickness of 1 µm.

Next, an Ir film (single crystal Ir film 23 in FIG. 5) was heteroepitaxially grown on a single crystal MgO (111) film 22 to form a laminate intermediate layer 21 composed of the Ir film/MgO.

An R.F. (13.56 MHz) magnetron sputtering method was used for forming the single crystal Ir film 23, in which an Ir target having a diameter of 8 inches (200 mm), a thickness of 5 mm, and a purity of 99.9% or more was used as a target. A substrate on which the single crystal MgO film 22 had been formed was heated to 900°C and then evacuated by a vacuum pump, and after confirming a base pressure of about 8.0×10⁻⁵ Pa or less, an Ar gas was introduced. After making a pressure of 13 Pa by adjusting an aperture of a valve connecting to an exhaust system, a film formation was performed for 30 minutes by inputting an R.F. 1500 W. A film thickness obtained was about 1 µm.

When a film thickness uniformity of the laminate intermediate layer composed of the Ir film/MgO film was evaluated, the film thickness uniformity was ±3.8%.

Crystallinity was measured from an outermost surface of the film by a pole method and an Out-of-plane method using an X-ray diffraction (XRD) apparatus (SmartLab manufactured by Rigaku Corporation). As a result, twin crystal components constituting Ir {111} were absent, only a diffracted intensity main peak at 2θ = 40.7° assigned to Ir (111) and a multiple reflection peak thereof were observed and it was confirmed that the surface of the intermediate layer was an epitaxially grown single crystal Ir (111) crystal.

In the above manner, the underlying substrate 20 shown in FIG. 5 was produced.

Next, a pretreatment (bias treatment) for forming a diamond nucleus was performed on the underlying substrate 20 (Step S13 in FIG. 2). Here, the underlying substrate 20, in which the intermediate layer 21 has been formed, was set on a planar electrode, and after confirming that a base pressure was about 1.3×10⁻⁴ Pa or less, hydrogen-diluted methane (CH₄/(CH₄+H₂) = 5.0 vol.%) was introduced into a treatment chamber at a flow rate of 500 sccm. After making the pressure 1.3×10⁴ Pa by adjusting the aperture of the valve connected to the exhaust system, a negative voltage was applied to the electrode at the substrate side to expose the substrate to plasma for 90 seconds, and thereby the surface of the intermediate layer 21 (that is, the surface of a single crystal Ir film (111) 23) was subjected to bias treatment.

Subsequently, a single crystal diamond layer 31 (undoped diamond film) was heteroepitaxially grown by a microwave CVD method (Step S14 in FIG. 2). Here, the bias-treated underlying substrate 20 was set in a chamber of a microwave CVD apparatus, and after being evacuated by a vacuum pump until a base pressure was about 1.3×10⁻⁴ Pa or less, and then hydrogen-diluted methane (CH₄/(CH₄+H₂) = 5.0 vol.%), being a raw material gas, was introduced into the treatment chamber at a flow rate of 1000 sccm. After making the pressure 1.5×10⁴ Pa by adjusting the aperture of the valve connected to the exhaust system, the film formation was performed for 100 hours with direct current applied. A substrate temperature during the film formation, which was measured with a pyrometer, was 980°C.

The single crystal diamond layer 31 obtained had no delamination on an entire surface, which had a diameter of 150 mm, and was a completely continuous film. A schematic cross-sectional view of the multi-layer substrate (single crystal diamond laminate substrate 30) is shown in FIG. 6.

Next, the α-Al₂O₃ wafer, being the initial substrate 11, was etched with hot phosphoric acid. Moreover, the laminate film of the single crystal MgO film 22 and the single crystal Ir film 22, being the intermediate layer 21, was removed by dry etching. Consequently, a single crystal diamond (111) freestanding substrate 35 was obtained (Step S15 in FIG. 2).

Finally, the single crystal diamond layer (additional single crystal diamond layer 41) was heteroepitaxially grown by the microwave CVD method again (Step S16 in FIG. 2). The formation of this additional single crystal diamond layer 41 was performed under the same condition as the formation of the undoped diamond film described above.

The single crystal diamond layer 41 obtained also had no delamination on an entire surface, which had a diameter of 150 mm, and was a completely continuous film. A schematic cross-sectional view of a single crystal diamond freestanding structure substrate 40 composed of the single crystal diamond layer 31 and the additional single crystal diamond layer 41 is shown in FIG. 8.

A 2 mm square was cut out from this single crystal diamond freestanding structure substrate 40 to make a sample for evaluation, and then an evaluation was performed for film thickness and crystallinity.

Regarding the film thickness, when the sample cross-section was observed by a scanning secondary electron microscope (SEM), a total thickness of the diamond layers was about 400 µm.

Crystallinity was measured from an outermost surface of the film by a pole method and an Out-of-plane method using an X-ray diffraction (XRD) apparatus (SmartLab manufactured by Rigaku Corporation). As a result, twin crystal components composing diamond {111} were also absent, only a diffracted intensity peak at 2θ = 43.9° assigned to diamond (111) was observed and it was confirmed that the diamond layer was an epitaxially grown single crystal diamond (111) crystal.

When the single crystal diamond (111) laminate substrate and the freestanding substrate are applied to an electronic and magnetic device, a high-performance device can be obtained. For example, a high-performance power device can be obtained.

Moreover, since the device can be obtained on a large-diameter substrate, the production cost can be kept low.

### (Example 2)

When the production is performed in the same way as in Example 1 except that the initial substrate 11 was a double-side polished single crystal α-Al₂O₃ wafer having a crystal plane orientation {0001} and an off angle of +8° in the <11-20> direction, a single crystal diamond (111) freestanding structure substrate 40 was obtained.

When a film thickness uniformity of the laminate intermediate layer composed of an Ir film/MgO film was evaluated, the film thickness uniformity was ±4.2%.

Crystallinity was measured from an outermost surface of the film by a pole method and an Out-of-plane method using an X-ray diffraction (XRD) apparatus (SmartLab manufactured by Rigaku Corporation). As a result, twin crystal components composing diamond {111} were absent, only a diffracted intensity peak at 2θ = 43.9° assigned to diamond (111) was observed, and it was confirmed that the diamond layer was epitaxially grown single crystal diamond (111) crystal.

### (Example 3)

When the production is performed in the same way as in Example 1 except that the initial substrate 11 was a double-side polished single crystal α-Al₂O₃ wafer having a crystal plane orientation {0001} and an off angle of +24° in the <11-20> direction, a single crystal diamond (111) freestanding structure substrate 40 was obtained.

When a film thickness uniformity of the laminate intermediate layer composed of an Ir film/MgO film was evaluated, the film thickness uniformity was ±6.5%.

Crystallinity was measured from an outermost surface of the film by a pole method and an Out-of-plane method using an X-ray diffraction (XRD) apparatus (SmartLab manufactured by Rigaku Corporation). As a result, twin crystal components composing diamond {111} were absent, only a diffracted intensity peak at 2θ = 43.9° assigned to diamond (111) was observed, and it was confirmed that the diamond layer was epitaxially grown single crystal diamond (111) crystal.

### (Example 4)

A single crystal α-Al₂O₃ wafer having a diameter of 150 mm, a thickness of 1000 µm, and a crystal plane orientation {0001}, and double-side polished was provided as an initial substrate 11.

Next, an MgO film was heteroepitaxially grown by a mist CVD method on a surface of the initial substrate to form a first layer of an intermediate layer 21 (single crystal MgO film 22 in FIG. 5) under the following conditions.

A "magnesium oxide aqueous solution" was used as a raw material solution in the mist CVD method. The raw material solution described above was stored in a mist generation source. Next, the flow rate control valve was opened to supply carrier gas from the carrier gas source into the chamber, and after sufficiently replacing the atmosphere in the chamber with the carrier gas, the flow rate of the carrier gas was adjusted to 10000 sccm, and the flow rate of the carrier gas for dilution was adjusted to 30000 sccm respectively. Oxygen was used as a carrier gas.

Next, an ultrasonic vibrator was vibrated at 2.4 MHz, and the vibration was propagated to the raw material solution through water, thereby atomizing the raw material solution to generate a mist. The mist was introduced into the chamber via a supply pipe by the carrier gas. Under atmospheric pressure, the initial substrate was set on a hot plate in a chamber and heated to 800°C, and the mist was caused to thermally react with the initial substrate to heteroepitaxially grow an MgO (111) film on the surface of the initial substrate 11 to a thickness of 1 µm.

Next, an Ir film was heteroepitaxially grown on a single crystal MgO (111) film 22 to form a laminate intermediate layer 21 composed of the Ir film/MgO.

An R.F. (13.56 MHz) magnetron sputtering method was used for forming the single crystal Ir film 23, in which an Ir target having a diameter of 8 inches (200 mm), a thickness of 5 mm, and a purity of 99.9% or more was used as a target. A substrate on which the single crystal MgO film 22 had been formed was heated to 900°C and then evacuated by a vacuum pump, and after confirming a base pressure of about 8.0×10⁻⁵ Pa or less, an Ar gas was introduced. After making a pressure of 13 Pa by adjusting an aperture of a valve connecting to an exhaust system, a film formation was performed for 30 minutes by inputting an R.F. 1500 W. A film thickness obtained was about 1 µm.

When a film thickness uniformity of the laminate intermediate layer composed of the Ir film/MgO film was evaluated, the film thickness uniformity was ±9.5%.

Crystallinity was measured from an outermost surface of the film by a pole method and an Out-of-plane method using an X-ray diffraction (XRD) apparatus (SmartLab manufactured by Rigaku Corporation). As a result, twin crystal components composing Ir {111} were contained, only a diffracted intensity main peak at 2θ = 40.7° assigned to Ir (111) and a multiple reflection peak thereof were observed and it was confirmed that the surface of the intermediate layer was epitaxially grown single crystal Ir {111} crystal which contains twin crystals.

In the above manner, the underlying substrate 20 shown in FIG. 5 was produced.

Next, a pretreatment (bias treatment) for forming a diamond nucleus was performed on the underlying substrate 20 (Step S13 in FIG. 2). Here, the underlying substrate 20, in which the intermediate layer 21 was formed, was set on a planar electrode, and after confirming that a base pressure was about 1.3×10⁻⁴ Pa or less, hydrogen-diluted methane (CH₄/(CH₄+H₂) = 5.0 vol.%) was introduced into a treatment chamber at a flow rate of 500 sccm. After making the pressure 1.3×10⁴ Pa by adjusting the aperture of the valve connected to the exhaust system, a negative voltage was applied to the electrode at the substrate side to expose the substrate to plasma for 90 seconds, and thereby the surface of the intermediate layer 21 (that is, the surface of a single crystal Ir film (111) 23) was subjected to bias treatment.

Subsequently, a single crystal diamond layer 31 (undoped diamond film) was heteroepitaxially grown by a microwave CVD method (Step S14 in FIG. 2). Here, the bias-treated underlying substrate 20 was set in a chamber of a microwave CVD apparatus, and after being evacuated by a vacuum pump until a base pressure was about 1.3×10⁻⁴ Pa or less, and then hydrogen-diluted methane (CH₄/(CH₄+H₂) = 5.0 vol.%), being a raw material gas, was introduced into the treatment chamber at a flow rate of 1000 sccm. After making the pressure 1.5×10⁴ Pa by adjusting the aperture of the valve connected to the exhaust system, the film formation was performed for 100 hours with direct current applied. A substrate temperature during the film formation, which was measured with a pyrometer, was 980°C.

The single crystal diamond layer 31 obtained had no delamination on an entire surface, which had a diameter of 150 mm, and was a completely continuous film. A schematic cross-sectional view of the multi-layer substrate (single crystal diamond laminate substrate 30) is shown in FIG. 6.

Next, the α-Al₂O₃ wafer, being the initial substrate 11, was etched with hot phosphoric acid. Moreover, the laminate film of the single crystal MgO film 22 and the single crystal Ir film 22, being the intermediate layer 21, was removed by dry etching. Consequently, a single crystal diamond (111) freestanding substrate 35 was obtained.

Finally, the single crystal diamond layer (additional single crystal diamond layer 41) was heteroepitaxially grown by the microwave CVD method again. The formation of this additional single crystal diamond layer 41 was performed under the same condition as the formation of the undoped diamond film described above.

The single crystal diamond layer 41 obtained also had no delamination on an entire surface, which had a diameter of 150 mm, and was a completely continuous film. A schematic cross-sectional view of a single crystal diamond freestanding structure substrate 40 composed of the single crystal diamond layer 31 and the additional single crystal diamond layer 41 is shown in FIG. 8.

A 2 mm square was cut out from this single crystal diamond freestanding structure substrate 40 to make a sample for evaluation, and then an evaluation was performed for film thickness and crystallinity.

Regarding the film thickness, when the sample cross-section was observed by a scanning secondary electron microscope (SEM), a total thickness of the diamond layers was about 400 µm.

Crystallinity was measured from an outermost surface of the film by a pole method and an Out-of-plane method using an X-ray diffraction (XRD) apparatus (SmartLab manufactured by Rigaku Corporation). As a result, twin crystal components composing diamond {111} were contained, only a diffracted intensity peak at 2θ = 43.9° assigned to diamond (111) was observed and it was confirmed that the diamond layer was an epitaxially grown single crystal diamond {111} crystal which contains twin crystals.

In particular, when the single crystal diamond {111} laminate substrate and the freestanding substrate without containing twin crystals as in Examples 1 to 3 are applied to an electronic and magnetic device, it is considered that performance degradation in using devices, such as a generation of leakage current, can be more effectively suppressed.

### (Comparative Example 1)

In Example 1, an MgO (111) film was formed by an electron beam vapor-deposition method under the conditions of vacuum and at a substrate temperature of 900°C until a single crystal MgO layer was epitaxially grown to a thickness of 1 µm. Except for the above, the conditions were the same as in Example 1. When a film thickness uniformity of a laminate intermediate layer composed of an Ir film/MgO film was evaluated, the film thickness uniformity was ±10.8%. In addition, the film forming time of the MgO film was five times or more longer than compared to Example 1.

### (Comparative Example 2)

In Example 1, an MgO (111) film was formed by an electron beam vapor-deposition method under the conditions of vacuum and at a substrate temperature of 900°C until a single crystal MgO layer was epitaxially grown to a thickness of 1 µm. Except for the above, the conditions were the same as in Example 1. When a film thickness uniformity of the laminate intermediate layer composed of an Ir film/MgO film was evaluated, the film thickness uniformity was ±13.1%. In addition, the film forming time of the MgO film was five times or more longer than compared to Example 4.

When a diamond film is formed on the intermediate layer having a poor film thickness uniformity (larger than ±10%) as in Comparative Examples 1 and 2, a risk is increased in which a single crystal diamond layer has degraded high crystallinity, increased hillocks, increased abnormal growth particles, increased dislocation defects, etc., high stress, and low quality. Moreover, when compared to a film formation by a mist CVD, an increase in film forming time thereof and the increase in equipment costs, etc., result in increased production costs of an underlying substrate, and a single crystal diamond laminate substrate.

The present description includes the following embodiments.
[1]: A method for producing an underlying substrate for a single crystal diamond laminate substrate, the method comprising the steps of:
   providing an initial substrate; and
   forming an intermediate layer comprising a single layer or a laminate film on the initial substrate containing at least a single crystal Ir film or a single crystal MgO film, wherein
   the single crystal Ir film or the single crystal MgO film composing the intermediate layer is formed by using a mist CVD method.
[2]: The method for producing an underlying substrate according to [1], wherein
   the initial substrate is any of a single crystal Si substrate, a single crystal α-Al₂O₃ substrate, a single crystal Fe substrate, a single crystal Ni substrate, and a single crystal Cu substrate.
[3]: The method for producing an underlying substrate according to the above [1] or [2], wherein
   the intermediate layer is a laminate film further containing at least any one of a single crystal yttria-stabilized zirconia film, a single crystal SrTiO₃ film, and a single crystal Ru film.
[4]: The method for producing an underlying substrate according to the above [1], [2] or [3], wherein
   the initial substrate is any of a Si {111} substrate, an α-Al₂O₃ {0001} substrate, a Fe {111} substrate, a Ni {111} substrate, and a Cu {111} substrate, and
   the intermediate layer contains at least an Ir film {111} or an MgO film {111}.
[5]: The method for producing an underlying substrate according to the above [4], wherein
   the intermediate layer further contains at least any one of a yttria-stabilized zirconia film {111}, a SrTiO₃ film {111}, and a Ru film {0001}.
[6]: The method for producing an underlying substrate according to the above [4] or [5], wherein
   an outermost surface on the initial substrate has an off angle in a crystal axis <-1-12> direction relative to a cubic crystal plane orientation {111} or has an off angle in a crystal axis <10-10> or <11-20> direction relative to a hexagonal crystal plane orientation {0001}.
[7]: The method for producing an underlying substrate according to the above [6], wherein
   the off angle of the outermost surface on the initial substrate is in a range of +8.0° to +24.0° or - 8.0° to -24.0°.
[8]: The method for producing an underlying substrate according to the above [6] or [7], wherein
   the off angle of the outermost surface on the initial substrate is in a range of greater than +15.0° to +24.0° or less, or greater than -15.0° to -24.0° or less.
[9]: The method for producing an underlying substrate according to the above [4], [5], [6], [7] or [8], wherein
   an outermost surface on the intermediate layer has an off angle in a crystal axis <-1-12> direction relative to a cubic crystal plane orientation {111} or has an off angle in a crystal axis <10-10> or <11-20> direction relative to a hexagonal crystal plane orientation {0001}.
[10]: The method for producing an underlying substrate according to the above [9], wherein
   the off angle of the outermost surface on the intermediate layer is in a range of +8.0° to +24.0° or - 8.0° to -24.0°.
[11]: The method for producing an underlying substrate according to the above [9] or [10], wherein
   the off angle of the outermost surface on the intermediate layer is in a range of greater than +15.0° to +24.0° or less, or greater than -15.0° to -24.0° or less.
[12]: The method for producing an underlying substrate according to the above [1], [2] or [3], wherein
   the initial substrate is any of a Si {001} substrate, an α-Al₂O₃ {11-20} substrate, a Fe {001} substrate, a Ni {001} substrate, and a Cu {001} substrate, and
   the intermediate layer contains at least an Ir film {001} or an MgO film {001}.
[13]: The method for producing an underlying substrate according to the above [12], wherein
   the intermediate layer further contains at least any one of a yttria-stabilized zirconia film {001}, a SrTiO₃ film {001}, and a Ru film {11-20}.
[14]: The method for producing an underlying substrate according to the above [12] or [13], wherein
   the outermost surface on the initial substrate has an off angle in a crystal axis <110> direction relative to a cubic crystal plane orientation {001} or has an off angle in a crystal axis <10-10> or <0001> direction relative to a hexagonal crystal plane orientation {11-20}.
[15]: The method for producing an underlying substrate according to the above [14], wherein
   the off angle of the outermost surface on the initial substrate is in a range of +8.0° to +24.0° or - 8.0° to -24.0°.
[16]: The method for producing an underlying substrate according to the above [14] or [15], wherein
   the off angle of the outermost surface on the initial substrate is in a range of greater than +15.0° to +24.0° or less, or greater than -15.0° to -24.0° or less.
[17]: The method for producing an underlying substrate according to the above [13], [14], [15] or [16], wherein
   the outermost surface on the intermediate layer has an off angle in a crystal axis <110> direction relative to a cubic crystal plane orientation {001} or has an off angle in a <10-10> or <0001> direction relative to a hexagonal crystal plane orientation {11-20}.
[18]: The method for producing an underlying substrate according to the above [17], wherein
   the off angle of the outermost surface on the intermediate layer is in a range of +8.0° to +24.0° or - 8.0° to -24.0°.
[19]: The method for producing an underlying substrate according to the above [17] or [18], wherein
   the off angle of the outermost surface on the intermediate layer is in a range of greater than +15.0° to +24.0° or less, or greater than -15.0° to -24.0° or less.
[20]: A method for producing a single crystal diamond laminate substrate, the method comprising the steps of:
   providing an underlying substrate produced by the method for producing an underlying substrate according to the above [1], [2], [3], [4], [5], [6], [7], [8], [9], [10], [11], [12], [13], [14], [15], [16], [17], [18], or [19];
   performing a bias treatment on a surface of the intermediate layer of the underlying substrate to form a diamond nucleus; and
   growing the diamond nucleus formed on the intermediate layer to perform epitaxial growth, thereby forming a single crystal diamond layer.
[21]: The method for producing a single crystal diamond laminate substrate according to the above [20], wherein
   the single crystal diamond layer is a {111} crystal.
[22]: The method for producing a single crystal diamond laminate substrate according to the above [20], wherein
   the single crystal diamond layer is a {001} crystal.
[23]: A method for producing a single crystal diamond freestanding structure substrate, the method comprising taking out only the single crystal diamond layer from a single crystal diamond laminate substrate produced by the method for producing a single crystal diamond laminate substrate according to the above [20], [21] or [22] to produce a single crystal diamond freestanding structure substrate.
[24]: A method for producing a single crystal diamond freestanding structure substrate, the method comprising further forming an additional single crystal diamond layer on a single crystal diamond freestanding structure substrate obtained by the method for producing a single crystal diamond freestanding structure substrate according to the above [23].
[25]: An underlying substrate for a single crystal diamond laminate substrate, the underlying substrate comprising:
   an initial substrate; and
   an intermediate layer comprising a single layer or a laminate film on the initial substrate containing at least a single crystal Ir film or a single crystal MgO film, wherein
   a film thickness uniformity of the intermediate layer on an entire surface is within ±10%.
[26]: The underlying substrate according to the above [25], wherein
   the initial substrate is any of a single crystal Si substrate, a single crystal α-Al₂O₃ substrate, a single crystal Fe substrate, a single crystal Ni substrate, and a single crystal Cu substrate.
[27]: The underlying substrate according to the above [25] or [26], wherein
   the intermediate layer is a laminate film further containing at least any one of a single crystal yttria-stabilized zirconia film, a single crystal SrTiO₃ film, and a single crystal Ru film.
[28]: The underlying substrate according to the above [25], [26] or [27], wherein
   the initial substrate is any of a single crystal Si {111} substrate, a single crystal Si {001} substrate, a single crystal α-Al₂O₃ {0001} substrate, a single crystal α-Al₂O₃ {11-20} substrate, a single crystal Fe {111} substrate, a single crystal Fe {001} substrate, a single crystal Ni {111} substrate, a single crystal Ni {001} substrate, a single crystal Cu {111} substrate, and a single crystal Cu {001} substrate, and
   an outermost surface on the initial substrate has an off angle in a crystal axis <-1-12> direction relative to a cubic crystal plane orientation {111}, or has an off angle in a crystal axis <10-10> or <11-20> direction relative to a hexagonal crystal plane orientation {0001}, or has an off angle in a crystal axis <110> direction relative to a cubic crystal plane orientation {001}, or has an off angle in a crystal axis <10-10> or <0001> direction relative to a hexagonal crystal plane orientation {11-20}.
[29]: The underlying substrate according to the above [28], wherein
   the off angle of an outermost surface on the initial substrate is in a range of +8.0° to +24.0° or - 8.0° to -24.0°.
[30]: The underlying substrate according to the above [28] or [29], wherein
   the off angle of the outermost surface on the initial substrate is in a range of greater than +15.0° to +24.0° or less, or greater than -15.0° to -24.0° or less.
[31]: The underlying substrate according to the above [25], [26], [27], [28], [29] or [30], wherein
   the outermost surface on the intermediate layer has an off angle in a crystal axis <-1-12> direction relative to a cubic crystal plane orientation {111}, or has an off angle in a crystal axis <10-10> or <11-20> direction relative to a hexagonal crystal plane orientation {0001}, or has an off angle in a crystal axis <110> direction relative to a cubic crystal plane orientation {001}, or has an off angle in a crystal axis <10-10> or <0001> direction relative to a hexagonal crystal plane orientation {11-20}.
[32]: The underlying substrate according to the above [31], wherein
   the off angle of the outermost surface on the intermediate layer is in a range of +8.0° to +24.0° or - 8.0° to -24.0°.
[33]: The underlying substrate according to the above [31] or [32], wherein
   the off angle of the outermost surface on the intermediate layer is in a range of greater than +15.0° to +24.0° or less, or greater than -15.0° to -24.0° or less.
[34]: A single crystal diamond laminate substrate comprising a single crystal diamond layer on the intermediate layer of the underlying substrate according to the above [25], [26], [27], [28], [29], [30], [31], [32] or [33].

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for producing an underlying substrate for a single crystal diamond laminate substrate, the method comprising the steps of:
providing an initial substrate; and
forming an intermediate layer comprising a single layer or a laminate film on the initial substrate containing at least a single crystal Ir film or a single crystal MgO film, wherein
the single crystal Ir film or the single crystal MgO film composing the intermediate layer is formed by using a mist CVD method.

2. The method for producing an underlying substrate according to claim 1, wherein
the initial substrate is any of a single crystal Si substrate, a single crystal α-Al₂O₃ substrate, a single crystal Fe substrate, a single crystal Ni substrate, and a single crystal Cu substrate.

3. The method for producing an underlying substrate according to claim 1, wherein
the intermediate layer is a laminate film further containing at least any one of a single crystal yttria-stabilized zirconia film, a single crystal SrTiO₃ film, and a single crystal Ru film.

4. The method for producing an underlying substrate according to claim 1, wherein
the initial substrate is any of a Si {111} substrate, an α-Al₂O₃ {0001} substrate, a Fe {111} substrate, a Ni {111} substrate, and a Cu {111} substrate, and
the intermediate layer contains at least an Ir film {111} or an MgO film {111}.

5. The method for producing an underlying substrate according to claim 4, wherein
the intermediate layer further contains at least any one of a yttria-stabilized zirconia film {111}, a SrTiO₃ film {111}, and a Ru film {0001}.

6. The method for producing an underlying substrate according to claim 4, wherein
an outermost surface on the initial substrate has an off angle in a crystal axis <-1-12> direction relative to a cubic crystal plane orientation {111} or has an off angle in a crystal axis <10-10> or <11-20> direction relative to a hexagonal crystal plane orientation {0001}.

7. The method for producing an underlying substrate according to claim 6, wherein
the off angle of the outermost surface on the initial substrate is in a range of +8.0° to +24.0° or - 8.0° to -24.0°.

8. The method for producing an underlying substrate according to claim 6, wherein
the off angle of the outermost surface on the initial substrate is in a range of greater than +15.0° to +24.0° or less, or greater than -15.0° to -24.0° or less.

9. The method for producing an underlying substrate according to claim 4, wherein
an outermost surface on the intermediate layer has an off angle in a crystal axis <-1-12> direction relative to a cubic crystal plane orientation {111} or has an off angle in a crystal axis <10-10> or <11-20> direction relative to a hexagonal crystal plane orientation {0001}.

10. The method for producing an underlying substrate according to claim 9, wherein
the off angle of the outermost surface on the intermediate layer is in a range of +8.0° to +24.0° or - 8.0° to -24.0°.

11. The method for producing an underlying substrate according to claim 9, wherein
the off angle of the outermost surface on the intermediate layer is in a range of greater than +15.0° to +24.0° or less, or greater than -15.0° to -24.0° or less.

12. The method for producing an underlying substrate according to claim 1, wherein
the initial substrate is any of a Si {001} substrate, an α-Al₂O₃ {11-20} substrate, a Fe {001} substrate, a Ni {001} substrate, and a Cu {001} substrate, and
the intermediate layer contains at least an Ir film {001} or an MgO film {001}.

13. The method for producing an underlying substrate according to claim 12, wherein
the intermediate layer further contains at least any one of a yttria-stabilized zirconia film {001}, a SrTiO₃ film {001}, and a Ru film {11-20}.

14. The method for producing an underlying substrate according to claim 12, wherein
the outermost surface on the initial substrate has an off angle in a crystal axis <110> direction relative to a cubic crystal plane orientation {001} or has an off angle in a crystal axis <10-10> or <0001> direction relative to a hexagonal crystal plane orientation {11-20}.

15. The method for producing an underlying substrate according to claim 14, wherein
the off angle of the outermost surface on the initial substrate is in a range of +8.0° to +24.0° or - 8.0° to -24.0°.

16. The method for producing an underlying substrate according to claim 14, wherein
the off angle of the outermost surface on the initial substrate is in a range of greater than +15.0° to +24.0° or less, or greater than -15.0° to -24.0° or less.

17. The method for producing an underlying substrate according to claim 13, wherein
the outermost surface on the intermediate layer has an off angle in a crystal axis <110> direction relative to a cubic crystal plane orientation {001} or has an off angle in a <10-10> or <0001> direction relative to a hexagonal crystal plane orientation {11-20}.

18. The method for producing an underlying substrate according to claim 17, wherein
the off angle of the outermost surface on the intermediate layer is in a range of +8.0° to +24.0° or - 8.0° to -24.0°.

19. The method for producing an underlying substrate according to claim 17, wherein
the off angle of the outermost surface on the intermediate layer is in a range of greater than +15.0° to +24.0° or less, or greater than -15.0° to -24.0° or less.

20. A method for producing a single crystal diamond laminate substrate, the method comprising the steps of:
providing an underlying substrate produced by the method for producing an underlying substrate according to any one of claims 1 to 19;
performing a bias treatment on a surface of the intermediate layer of the underlying substrate to form a diamond nucleus; and
growing the diamond nucleus formed on the intermediate layer to perform epitaxial growth, thereby forming a single crystal diamond layer.

21. The method for producing a single crystal diamond laminate substrate according to claim 20, wherein
the single crystal diamond layer is a {111} crystal.

22. The method for producing a single crystal diamond laminate substrate according to claim 20, wherein
the single crystal diamond layer is a {001} crystal.

23. A method for producing a single crystal diamond freestanding structure substrate, the method comprising taking out only the single crystal diamond layer from a single crystal diamond laminate substrate produced by the method for producing a single crystal diamond laminate substrate according to claim 20 to produce a single crystal diamond freestanding structure substrate.

24. A method for producing a single crystal diamond freestanding structure substrate, the method comprising further forming an additional single crystal diamond layer on a single crystal diamond freestanding structure substrate obtained by the method for producing a single crystal diamond freestanding structure substrate according to claim 23.

25. An underlying substrate for a single crystal diamond laminate substrate, the underlying substrate comprising:
an initial substrate; and
an intermediate layer comprising a single layer or a laminate film on the initial substrate containing at least a single crystal Ir film or a single crystal MgO film, wherein
a film thickness uniformity of the intermediate layer on an entire surface is within ±10%.

26. The underlying substrate according to claim 25, wherein
the initial substrate is any of a single crystal Si substrate, a single crystal α-Al₂O₃ substrate, a single crystal Fe substrate, a single crystal Ni substrate, and a single crystal Cu substrate.

27. The underlying substrate according to claim 25, wherein
the intermediate layer is a laminate film further containing at least any one of a single crystal yttria-stabilized zirconia film, a single crystal SrTiO₃ film, and a single crystal Ru film.

28. The underlying substrate according to claim 25, wherein
the initial substrate is any of a single crystal Si {111} substrate, a single crystal Si {001} substrate, a single crystal α-Al₂O₃ {0001} substrate, a single crystal α-Al₂O₃ {11-20} substrate, a single crystal Fe {111} substrate, a single crystal Fe {001} substrate, a single crystal Ni {111} substrate, a single crystal Ni {001} substrate, a single crystal Cu {111} substrate, and a single crystal Cu {001} substrate, and
an outermost surface on the initial substrate has an off angle in a crystal axis <-1-12> direction relative to a cubic crystal plane orientation {111}, or has an off angle in a crystal axis <10-10> or <11-20> direction relative to a hexagonal crystal plane orientation {0001}, or has an off angle in a crystal axis <110> direction relative to a cubic crystal plane orientation {001}, or has an off angle in a crystal axis <10-10> or <0001> direction relative to a hexagonal crystal plane orientation {11-20}.

29. The underlying substrate according to claim 28, wherein
the off angle of an outermost surface on the initial substrate is in a range of +8.0° to +24.0° or - 8.0° to -24.0°.

30. The underlying substrate according to claim 28, wherein
the off angle of the outermost surface on the initial substrate is in a range of greater than +15.0° to +24.0° or less, or greater than -15.0° to -24.0° or less.

31. The underlying substrate according to claim 25, wherein
the outermost surface on the intermediate layer has an off angle in a crystal axis <-1-12> direction relative to a cubic crystal plane orientation {111}, or has an off angle in a crystal axis <10-10> or <11-20> direction relative to a hexagonal crystal plane orientation {0001}, or has an off angle in a crystal axis <110> direction relative to a cubic crystal plane orientation {001}, or has an off angle in a crystal axis <10-10> or <0001> direction relative to a hexagonal crystal plane orientation {11-20}.

32. The underlying substrate according to claim 31, wherein
the off angle of the outermost surface on the intermediate layer is in a range of +8.0° to +24.0° or - 8.0° to -24.0°.

33. The underlying substrate according to claim 31, wherein
the off angle of the outermost surface on the intermediate layer is in a range of greater than +15.0° to +24.0° or less, or greater than -15.0° to -24.0° or less.

34. A single crystal diamond laminate substrate comprising a single crystal diamond layer on the intermediate layer of the underlying substrate according to any one of claims 25 to 33.
